# EUROPEAN PATENT APPLICATION

(11) **EP 3 637 453 A1**
(43) Date of publication of application: **15.04.2020**
(21) Application number: 19199480.5
(22) Date of filing: 25.09.2019
(51) Int. Cl.: H01J 37/20, H01J 37/305, B25J 7/00, H01J 37/26, H01J 37/295

(54) **GIS WELDED MICROMANIPULATOR EXTENSIONS**

(30) Priority: 29.09.2018 CN 201821605469 U
(71) Applicant: FEI Company, Hillsboro, OR 97124-5793 (US)
(72) Inventor: Routh, Jr. Mr. Brian, Beaverton, OR Oregon 97008 (US)
(74) Representative: Janssen, Francis-Paul

(57) **Abstract**

The present invention provides a chip comprising: a substrate; a plurality of rods which are freestanding and spaced from the substrate and spaced from each other, wherein each rod has, longitudinally, a first end portion and a second end portion; connectors for connecting each of the plurality of rods at both longitudinal end portions thereof respectively and holding them to the substrate, wherein each rod can be individually raised away from the chip for use by a micromanipulator by cutting a rod from the connectors at both first and second end portions thereof. The present invention also provides a micromanipulator and a system for preparing a micromanipulator.

## Description

### Technical field

The present utility model involves a chip including a plurality of lift-out needles used by a micromanipulator, a micromanipulator and a system for preparing the micromanipulator.

### Background

Lift-out (LO) techniques have been exploited for site-specific transmission electron microscopy (TEM) and other analytical usage. With lift-out techniques, specimens may be prepared from the starting bulk sample with little or no initial specimen preparation. This is particularly useful when performing failure or defect analysis, since destructive preparation of the original wafer or bulk sample may be avoided.

Using the lift-out technique requires either a micromanipulator station for ex-situ LO (EXLO), or a vacuum compatible micromanipulator probe assembly for in-situ LO (INLO). For example, as well-known in the art, a micromanipulator or a micromanipulator assembly is used to transfer lamella from a bulk sample to a TEM (transmission electron microscopy) grid for further thinning (for example, the lamella is thinned to electron transparency) and/or analysis.

According to current practice, lamella lift-out techniques additionally involve a step, usually an automated step, to in-situ shape (e.g., FIB (focused ion beam) mill) an end of the micromanipulator into a rod, e.g., needle, which is approximately 1.5-2µm square and 50-70µm long (as measured from the FIB with no angle compensation).

For example, as described in JP2010181339, a micromanipulator tip part is treated with a Focused Ion Beam prior to removing material from the tip part to form the desired needle shape and size. The micromanipulator tip part is FIB-milled from different directions by a moving mechanism for changing position and orientation. Even in the presence of contamination and damage in a manipulator tip during the operation, the manipulator tip is regenerated into a reusable shape by the FIB.

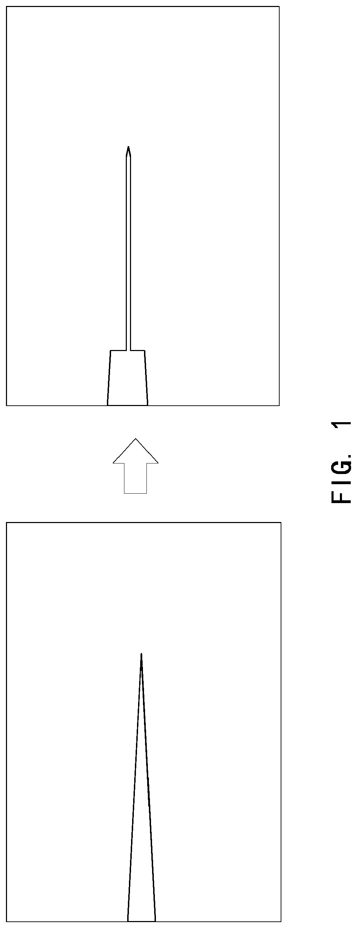

However, even if there's no contamination or damage during the operation, the formed needle will be continually consumed during the lift-out process. For example, some of the needle is consumed each time a lamella is dropped off on the lift-out grid in addition to being repeatedly milled into the desired needle shape and size. So, the needle end of the micromanipulator must be reformed (i.e., re-milled) once the rod is used up: 2µm is consumed per planar and top-down lamella, and 3µm is consumed per inverted lamella. For example, the end form of an EasyLift needle (a type of needle in the prior art) is controlled by periodic FIB re-shaping from a cone to a long square prism, i.e., the needle.
As the needle is consumed, the amount of material removed by the probe-sharpening process (as shown in figure 1) increases and the time required to shape the end form of the EasyLift needle increases accordingly. For example, it takes about 30-75 minutes to reform the end form into the desired needle. Finally, at some point, it becomes impractical to reform the end form into the desired needle and the chamber must be vented in order to replace the end form with a new one. All of this reduces system uptime and makes the whole operation inefficient.

So, there is a need in the art to greatly reduce the amount of time required to manage the micromanipulator end form. A process which can be accomplished in a few minutes is desirable. Additionally, a much lower frequency of exchanging the end form of the micromanipulator is very important to the whole lift-out process.

### Summary

In a first aspect, the present invention provides a chip comprising: a substrate; a plurality of rods which are freestanding and spaced from the substrate and spaced from each other, wherein each rod has, longitudinally, a first end portion and a second end portion; connectors for connecting each of the plurality of rods at both longitudinal end portions thereof respectively and holding them to the substrate, wherein each rod can be individually raised away from the chip for use by a micromanipulator by cutting a rod from the connectors at both first and second end portions thereof.

By means of such a chip, a rod can be easily produced for attaching onto the end of the micromanipulator, which the rod then becomes the desired needle. This is a much faster process and can be accomplished in a few minutes. Also, the end form will need to be exchanged and the specimen chamber will be vented far less frequently resulting in greater uptime for the tool and process.

Preferably, the rods and the connectors can be formed integrally.

Ideally, the connectors include anchors directly extending from the substrate, and further include tabs, spaced from the substrate, for connecting the rods to the connectors on both first and second end portions thereof respectively. Anchors and tabs are used to connect the rods to the substrate in a simple and reliable way to form chip.

It is possible that the tabs are configured in such a way that they can be cut off in order to release each rod from the connectors at both first and second end portions thereof.

Further, each rod may have a free tip at the first and the second end portions thereof respectively for attachment to the micromanipulator in situ.

In a second aspect, the present invention provides a micromanipulator comprising a free end, wherein the free end of the micromanipulator has a needle attached thereto which is configured as the rod cut from the chip mentioned above. Such a micromanipulator would greatly reduce the amount of time required to manage the needle end form.

In a third aspect, the present invention provides a system for preparing a micromanipulator comprising: a chip defined above; a micromanipulator defined above and means for fixedly attaching a rod to the free end of the micromanipulator.

Preferably, the system further includes a fixture on which the chip is mounted in such a way that the rod is oriented at an angle matching the free end of the micromanipulator and the first end portion of the rod abuts against the free end of the micromanipulator.

In particular, the system may further include cutting means for dicing the rods from the chip with the first end portion cut firstly and the second end portion secondly.

Ideally, the system further includes means for rotating the chip to face the cutting means and/or means for rotating the rods for attachment thereof to the micromanipulator.

It is conceivable that the free end of the micromanipulator can be shaped to conform to the shape of the free tip of each rod.

In a fourth aspect, the present invention provides a chip comprising: a substrate; a plurality of rods which are spaced from the substrate and spaced from each other, wherein each rod has, longitudinally, a first end portion and a second end portion; tabs for connecting each of the plurality of rods to at least one of the first end portion and the second end portion thereof; and
support elements for holding the rods and tabs to the substrate, wherein each rod can be individually raised away from the chip for use by a micromanipulator by cutting a rod from its tabs.

By means of such a chip, a rod can be easily cut off from the chip and attached onto the end of the micromanipulator. Also, the end form will need to be exchanged and the specimen chamber will be vented far less frequently resulting in greater uptime for the tool and process.

Preferably, the rods are supported via the support elements by the substrate at least at one end of the substrate.

Advantageously, the chip further includes piers beneath the support elements and on the substrate for connecting the support elements to the substrate. In this case, anchors may not make it all the way to the substrate (i.e. there's no anchor which extends into the substrate) and instead the piers do connect to the substrate.

### Brief description on drawings

The accompanying drawings are included to provide a further understanding of the disclosure and are incorporated in and constitute a part of this specification, illustrate embodiments, and together with the description serve to explain the principles of the disclosure.
Figure 1 is an illustration of a needle of a micromanipulator which has been sharpened from a conic one in known in the prior art;
Figure 2 shows a first embodiment of a method for producing extension rods in which channels and holes have been formed into the removable material or through the removable material and into the substrate;
Figure 3 is an illustrative perspective view of a chip containing multiple rods with connectors therebetween;
Figure 4 is an illustrative plan view of a chip with some tabs having been cut away to release one end of the rod from the chip;
Figure 5 is an illustrative view of a method step of aligning the micromanipulator with one end of the rod;
Figure 6 is an illustrative view of an embodiment of the dual beam system for attaching the rod to the free end of the micromanipulator;
Figure 7 is an illustrative view of an example of hardware of the system shown in figure 6;
Figure 8 shows a second embodiment of a method for producing extension rods in which a layer of rod material has been deposited on the substrate;
Figure 9 shows a second embodiment of a method for producing extension rods in which photoresist has been deposited on the layer of rod material;
Figure 10 shows a second embodiment of a method for producing extension rods in which photoresist has been exposed via photolithography;
Figure 11 shows a second embodiment of a method for producing extension rods in which the pattern of photoresist has been developed;
Figure 12 shows a second embodiment of a method for producing extension rods in which the layer of rod material has been etched according to the pattern;
Figure 13 shows a second embodiment of a method for producing extension rods in which photoresist has been stripped;
Figure 14 shows a second embodiment of a method for producing extension rods in which a part of the substrate has been etched; and
Figure 15 is an illustrative perspective view of a chip made according to the embodiment shown in figures 8-12.

### Detailed description on embodiments

Persons skilled in the art will readily appreciate that various aspects of the present disclosure can be realized by any number of methods and apparatuses configured to perform the intended functions. It should also be noted that the accompanying figures referred to herein are not necessarily drawn to scale, but may be exaggerated to illustrate various aspects of the present disclosure, and in that regard, the figures should not be construed as limiting.

The present disclosure relates to a micromanipulator and attachments thereto that are used to transfer lamella from a bulk sample. Instead of in-situ shaping and sharpening the end part of the micromanipulator into a desired needle shape after it is worn down and/or between uses, a prefabricated rod (or a prefabricated extension) will be attached onto the free end of the micromanipulator to provide the desired needle.

The rod may be affixed to the end of the micromanipulator in various ways, such as by welding, bonding or any other known mechanism to provide the desired needle. For example, when the rod is mechanically attach to the manipulator, a carrier with a rod is put in the system and attached onto the end of the manipulator using a suitable mechanical retention system. Other chemistry-free techniques to use re-deposited material from FIB sputtering to affix the rod to the manipulator end are also possible. But welding is preferred due to lower requirement on the structure of the needle, less time and higher reliability on structural stability.

When compared with in-situ milling hard tungsten needles from manipulator end forms, additional (or separate) attachment of a rod onto the end of the micromanipulator is a much faster process and can be accomplished in a few minutes, for example by means of welding with a GIS (Gas Injection System, typically in conjunction with either an electron beam or an ion beam to obtain electron beam induced deposition (EBID) or ion beam induced deposition (IBID) of the welding material, e.g., tungsten). Additionally, the end of the micromanipulator will need to be exchanged and the specimen chamber will be vented far less frequently since the end of the micromanipulator is not or at least less consumed.

In the present disclosure, differently shaped prefabricated rods are disclosed. The cross-section of a rod may be round, square, rectangular, elliptical, triangle or of any other suitable regular or irregular shape. Further, the rods may also be different lengths. The rods can be different materials or build techniques. Since a longer section of material, as a rod, can be attached to the micromanipulator to provide the needle, overall efficiency during the operation will be largely improved. For example, once a needle is consumed, a new rod may be attached, such as welded, to the end of the micromanipulator instead of replacing the end of the micromanipulator, which requires system down time.

In some embodiments, rods are produced either in-situ in the FIB microscope (for example, using tungsten deposition and XeF2 on a pre-fabricated mold), while in other embodiments they are prefabricated ex-situ (for example, in another working station or even totally separately from the whole operation).

Rods may be prefabricated individually, but it is preferable that they are prefabricated in a mass production so that these rods are far more repeatable in their size and shape. But in either case, it is desirable to store a large number of prefabricated rods in a tool inside of the system (for example in a charged particle microscope or similar device), thus eliminating the need to vent and re-pump the specimen chamber every time one of the rods is consumed.

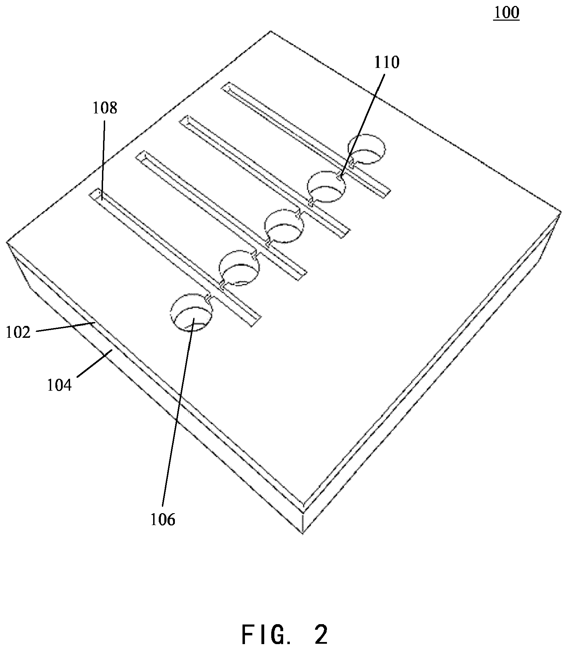

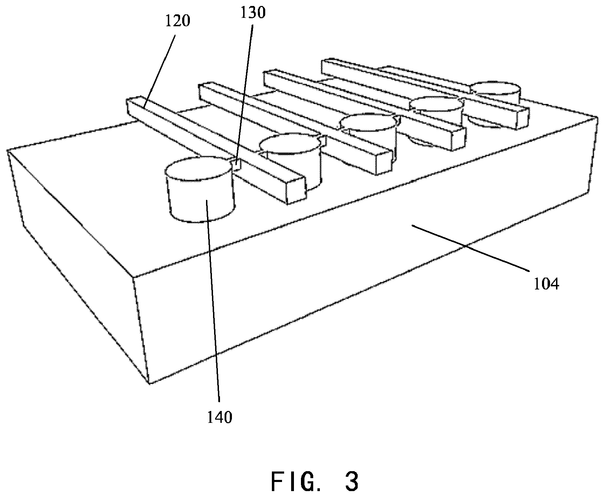

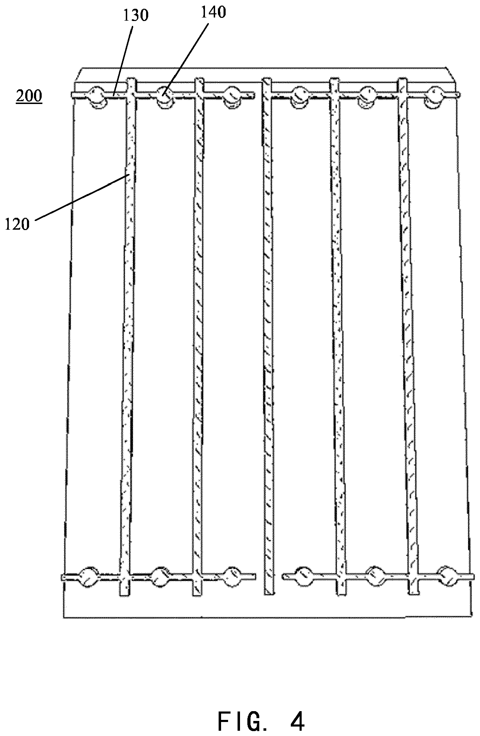

A first embodiment of producing such a rod is to use a substrate, such as a silicon wafer (referred to as a mold 100) which will be explained in detail (as shown in figures 2-3) now.
- In a first step, a layer of an easily removable material 102 (also called "a sacrificial layer") is deposited on a substrate 104, such as a bare silicon substrate. Alternatively, the removable material 102 may be grown on top of the substrate 104. The removable material 102 can be silicon oxide, silicon nitride, polyimide, or any other material known in the art. The substrate 104 includes a first end portion and a second end portion which are opposite to each other on the substrate 104. The removable material 102 also has corresponding end portions thereon. The term "end portion" may be either longitudinal or lateral end portion in context of the present disclosure.
- In a second step, a plurality of holes 106 are formed (for example, etched) through the removable material 102 and into the substrate 104.
   In most cases, each hole extends through the removable material 102 and into the substrate 104 and thus the hole in the removable material 102 aligns with the hole in the substrate 104 below it. All possible shapes of holes are contemplated herein, such as a taper hole or a hole with several steps.
   Advantageously, these holes 106 are positioned in a line or lines on the substrate 104. There are at least some holes 106 formed near an end of an eventual chip portion of the substrate 104, in particular a first end portion of the eventual chip. Preferably, holes 106 are divided into two groups, namely a plurality of first holes and a plurality of second holes which are located opposite to each other on the eventual chip 200 (and the removable material 102), i.e. on opposite end portions of the chip 200 (and the removable material 102). The number of the plurality of first holes may be or may not be the same as the number of the plurality of second holes. In an embodiment, as best shown in figure 4, the plurality of first holes and the plurality of second holes are located near the first end portion and the second end portion of the substrate 104 respectively.
- In a third step, as best shown in figure 2, a plurality of channels are formed (for example, etched) into the removable material 102 but not into the substrate 104.
   A plurality of first channels 108 are formed from one end portion of the removable material 102 to the other. When there are only a plurality of first holes on the substrate 104 and in the removable material 102, the plurality of first channels 108 may extend between the plurality of first holes and the other end (i.e. the second end portion) of the removable material 102. When there are both plurality of first holes and the plurality of second holes, the plurality of first channels 108 may extend between the plurality of first holes and the plurality of second holes in the removable material 102.
   It is noted, however, the phrase "A extends between B and C" is not limited to direct connection between A and B or between A and C but just describes relative location of A with respect to B and C.
   Alternatively, it may be advantageous that the plurality of first channels 108 extend beyond the plurality of first holes and/or the plurality of second holes (but still within the boundary of the removable material 102), but extension of the first channels 108 beyond the first and/or second holes is not necessary.
   A plurality of second channels 110 may be formed between adjacent plurality of first holes or adjacent plurality of second holes. In other words, the plurality of second channels 110 may individually extend from a first hole or a second hole to a respective one of the channels of the plurality of first channels 108 so that the plurality of first holes and the plurality of second holes are connected.
   In the present disclosure, the second step and the third step may, without doubt, exchange their sequences without influencing the production of the rods 120.
- In a fourth step, filling material such as tungsten is deposited onto the chip 200, filling the holes 106 and channels formed in the removable material 102 and the substrate 104. In this step, a number of rods 120 and their connectors 130 are formed.
- In a fifth step, which is an optional step, the chip is chemical mechanical polished (CMPed) to the top of the removable layer for re-planarizing the chip.
- In a sixth step, the removable layer (i.e. the sacrificial layer) is removed from the substrate 104 and the rods 120 and their connectors 130 are exposed. For example, the sacrificial layer encasing the tungsten rods is etched away. Subsequent to removal of the sacrificial layer, the substrate 104 is diced to form the chips 200.
   As best shown in figure 3, the rods 120 are connected with each other at least on one end thereof, preferably on both ends thereof. The rods 120 may extend beyond their connectors 130 and thus have, individually, free ends on one side or on both sides respectively.
   Since the rods 120 and their connectors 130 are formed by filling the first and second channels 108, 110 with for example tungsten only in the removable layer 102, they are spaced from the substrate 104 below them. The connectors 130 for connecting the rods 120 at one end or both ends thereof may be referred also as "tabs".
   The rods 120 and their tabs 130 are connected to the substrate 104 by means of so-called posts or anchors 140 which are formed by filling the first and second holes with filling material for example tungsten in both the removable layer and the substrate 104. So, the tungsten rods 120 will be freestanding except for a few tungsten tabs 130 connected to un-etched areas of the Si substrate by these posts 140.

The substrate 104 including a number of rods 120 and their connectors 130 with the rods having free ends may be called as "a chip" in context of the present disclosure. While figures 2-3 show the chip 200, the plurality of rods and the process of forming the rods on the chip 200, it should be understood that the process would likely be performed on a wafer that is subsequently diced or cleaved to form the individual chips 200 containing the plurality of rods. The chips 200 may be diced after the removable layer has been removed from the substrate. This is more suitable for mass production of rods. In the latter case, above mentioned holes and channels may be formed in arrays on a wafer, and in particular channels for forming the rods may be long and continuous channels (especially linear channels which are parallel to each other) with holes lined up on respective channels.

Each rod 120 on the chip 200 may be cut away from the substrate 104, for example by cutting the connectors 130 (i.e. tabs) between two adjacent rods 120. The cutting step will be performed by any conventional cutting means known in the art.

In addition, it is possible to etch features into the channels to act as fiducials in the finished rod. These fiducials can assist the machine vision in locating the micromanipulator end and/or serve as a visual indicator of how much of the rod remains. Adding fiducials to the rods offers excellent opportunities to improve automated lift-out processes and automate the process to determine when a rod is used up.

The above-mentioned steps just belong to an illustrative example of producing rods. The cross sections of the channels and sizes of both channels and holes are not limited and can be varied according to actual demand.

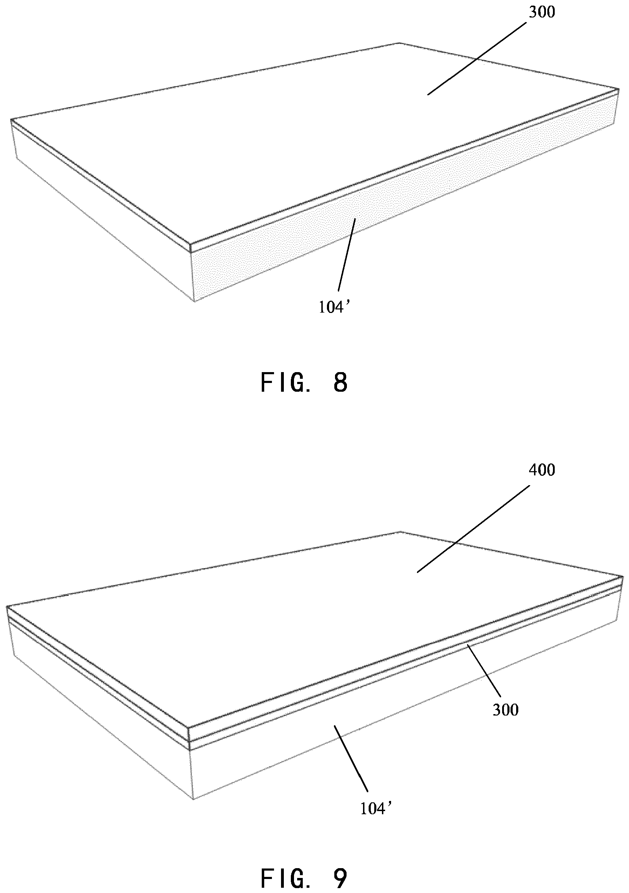

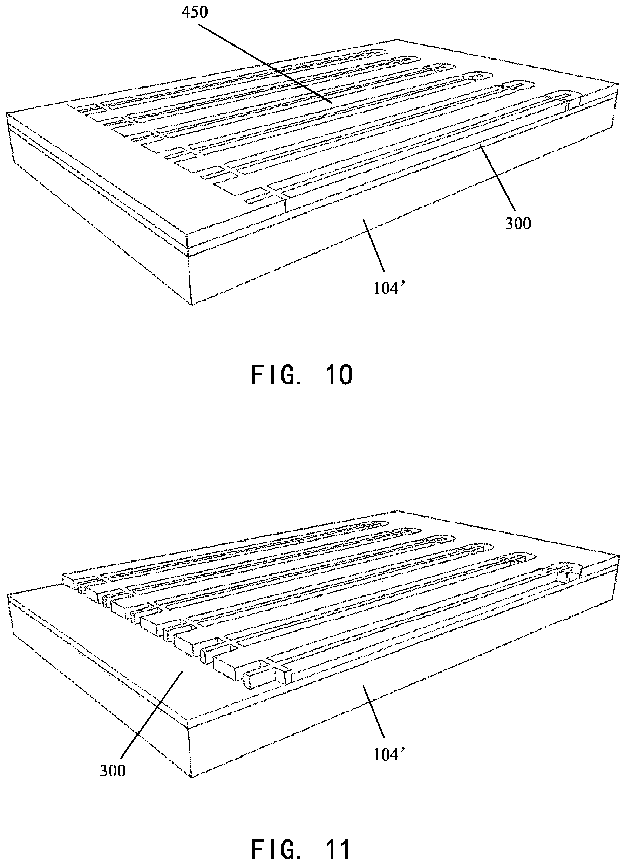

Alternatively, a second embodiment of producing a chip with rods is to etched a layer of rod material and a part of the substrate (or other sacrificial layer) directly. The main differences between the first and second embodiments (as shown in figures 8-13) will be explained in detail now.
- In a first step, a substrate is provided (for example, a silicon substrate). The substrate includes a first end portion and a second end portion which are opposite to each other on the substrate.
- In a second step, a layer of rod material is deposited or alternatively grown on the above substrate. Any layer between the layer of rod material and the substrate is not excluded here. The term "layer of rod material" means a layer of material which is used to make rods or rods are formed directly from this layer of rod material.
- In a third step, said layer of rod material may be formed, especially etched, into a plurality of rods with tabs connected between two adjacent rods. The rods extend from the first end portion to the second end portion and have two opposite free ends respectively. Further, there are support elements in said layer of rod material to which said tabs are connected. In other words, the remaining portions of the layer of rod material, after etching, at least includes rods, tabs and support elements. Isotropic etching is preferable here. Etching can either be dry or wet etching. Other methods such as laser milling are less manufacturing friendly and more costly.
- In a fourth step, a layer of material underneath said layer of rod material may be formed, especially etched, in such a way that this layer of material provides only support to the support elements of the layer of rod material. Anisotropic etching is preferable here.

Preferably, depending on the choice of metal chosen for the rods (and also the layer of rod material), there may be a sacrificial layer deposited or grown on top of the substrate, underneath the rod material. The sacrificial layer or the layer of removable material may be deposited or grown on top of the substrate before above second step. In this case, said etched layer of material underneath said layer of rod material involves said layer of removable material. But when no sacrificial layer is provided, said etched layer of material underneath said layer of rod material involves a part of the substrate.

Moreover, this sacrificial layer or this layer of removable material may be chosen such that there exists an anisotropic etch that will preferentially etch the sacrificial layer and not damage the rod material layer. For instance, if tungsten is selected as the rod material, then a sacrificial layer of SiOx will be used underneath the rod material layer and HF will be used to etch the SiOx but leave the tungsten. If aluminum is used to make rods, then no sacrificial layer will be created and XeF2 will be used the etch the Si substrate but leave the aluminum.

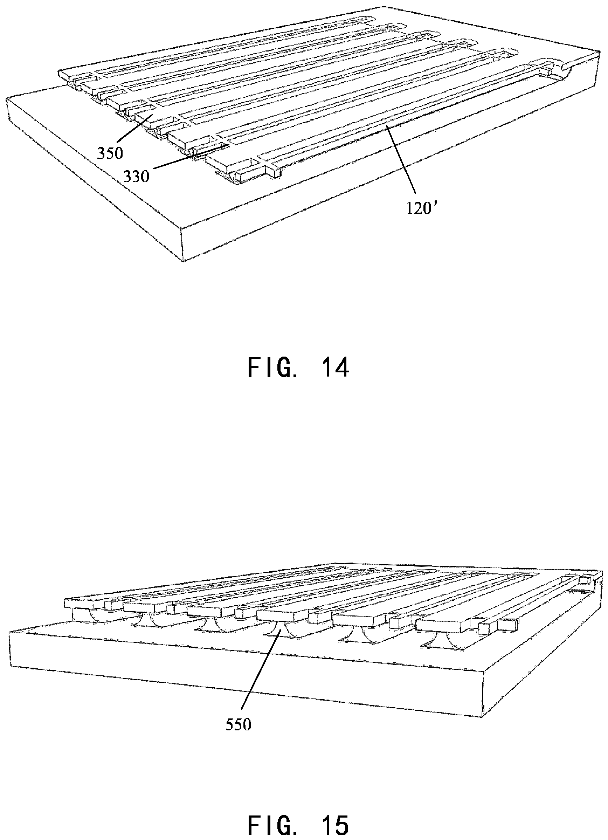

In the embodiment shown in figures 8-15, the support elements of the layer of rod material includes end portions at or near one of the first end portion and the second end portion of the substrate. The layer of material underneath said layer of rod material is etched in such a way to provide support to the end portions of the support elements.

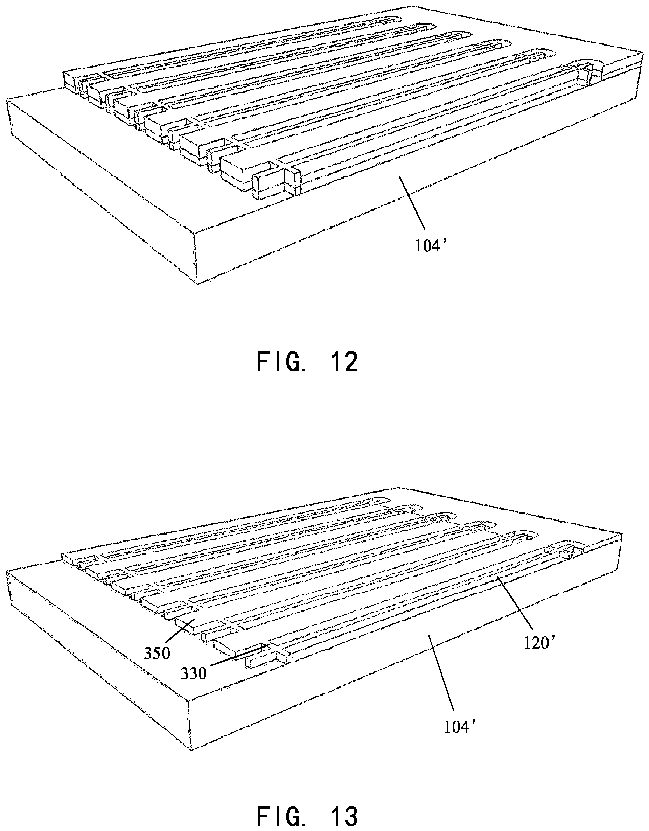

But it is understood that such support is not limited to the end portions. As best shown in figure 13, said layer of material underneath said layer of rod material is etched in such a way that piers are formed beneath the support elements of the layer of rod material to support them.

Further, the second embodiment of method may further include a step of depositing or growing photoresist on top of the layer of rod material and forming said photoresist into a pattern for example via photolithography before the third step. In this case, in the third step, said layer of rod material is etched according to said pattern. Deviation from this pattern is however not excluded here.

According to the above mentioned second embodiment, a chip with rods may be formed with tabs for connecting rods and support elements for holding the rods and tabs to the substrate. In other words, the rods may be supported via the support elements by the substrate, for example at one end of the substrate. Also, piers are conceivable as support (media) between the support elements of the layer of rod material and the substrate.

In the second embodiment, when compared with the first embodiment, anchors may not necessarily make it all the way to the substrate (i.e. there's no anchor which extends into the substrate as the case in the first embodiment) and the piers do connect to the substrate. If there's optionally a sacrificial layer on top of the substrate in the second embodiment, no anchor has to touch the substrate at all since piers, etched from the sacrificial layer, extend between the substrate and the layer of rod material (i.e. the support elements thereof).

So, in the second embodiment, anchor design of the first embodiment has been changed from posts sunken into the substrate to piers connecting the rods (mechanically and/or electrically) to the rest of the top rod material layer. This allows for greater flexibility in terms of choosing a sacrificial layer, while still retaining the ability to electrically ground the rods. As a side benefit, this also affords the rods some measure of protection from physical damage during handling since they are not standing proud of the substrate (or at least no provisions need to be made to recess them into the substrate).

Next, an illustrative embodiment of mounting the rod to the micromanipulator in situ will be described as shown in figures 4-5.

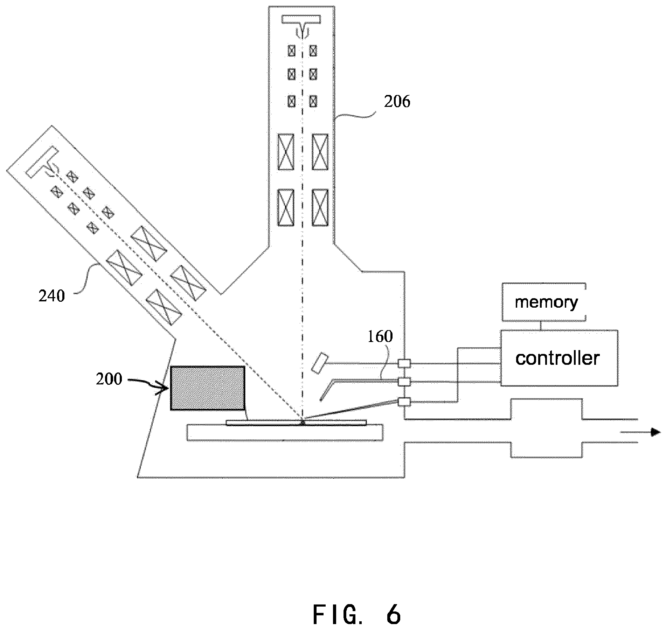

For attaching the rod to the micromanipulator, a system (pis. see dual beam system shown in figures 6-7) or a working station is involved in the present disclosure.

Such system at least includes, in addition to the micromanipulator 160 and the chip 200, means for fixedly attaching a rod 120 to the free end of the micromanipulator 160. Such means may include several components which will be explained further below. Further, the system includes a chip inventory box for storing the chips that can be used when needed.

For example, the system may include a fixture (not shown in figures) on which the chip 200 is mounted in such a way that the rod 120 in this chip 200 is oriented at an angle matching the free end of the micromanipulator 160 and the first end portion 122 of the rod 120 abuts against the free end of the micromanipulator 160. Alternatively, it is also possible to orient the whole chip at an angle matching the free end of the micromanipulator so that the plurality of rods may be oriented to match the angle. In some cases, the micromanipulator 160 end also needs some minor shaping to a point so that it can be welded to the pre-fabricated rod, but this is not necessary in other cases.

In an embodiment in which the rod 120 is welded onto the micromanipulator 160 (for example, by using standard tungsten GIS process), the chip 200 is rotated to face the FIB. Here, means for rotating the chip 200 to face the cutting means and/or means for rotating the rods for attachment thereof to the micromanipulator 160 may be additionally included in the system.

Then, all but one of the tabs 130 for this rod 120 are cut, as clearly shown in figure 4. For a rod 120 with tabs 130 on both longitudinal ends for connecting the adjacent rods, three cuts are made in this step. For a rod 120 with tabs 130 only on one end thereof, one cut is made. In this case, the system includes cutting means for dicing the rods 120 from the chip 200 with the first end portion cut firstly and the second end portion secondly.

Alternatively, two directly adjacent tabs may be uncut until attachment to the free end of the micromanipulator (separation from the substrate), for example welding, is performed. In this case, leaving two closest tabs (instead of a single tab) uncut works better for welding with as little bending as possible.

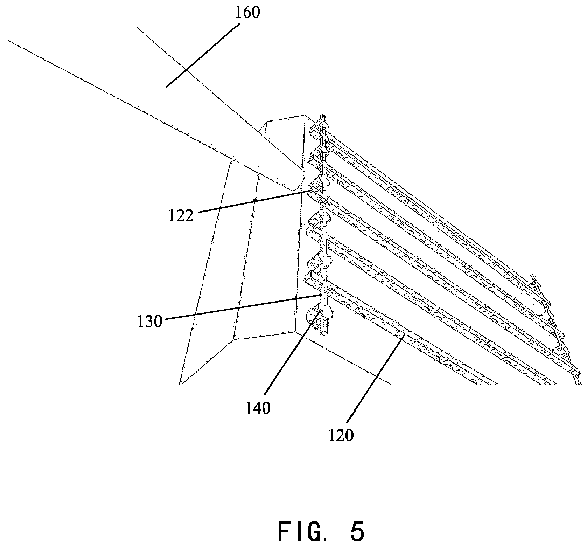

Once the tabs are cut, the chip 200 is rotated such that the rod 120 is parallel to the micromanipulator 160, as shown in figure 5. Then, the tungsten rod 120 is welded to the tungsten needle using tungsten IBID (or some other material). The final tab is cut and the rod is raised away from the chip 200.

Once the rod 120 is attached to the free end of the micromanipulator (separation from the substrate), the weld can be reinforced by rotating the rod 120 (for example, by 180 degrees, to reinforce the weld from the other side thereof) and adding more tungsten at the joint. But this step is optional. The micromanipulator 160 is then realigned to the end of the extension and used until the rod 120 is consumed.

It should be noted that since the fixture in this system might be small and probably be left in a specimen chamber, the entire weld procedure for a new rod could be completely automated and seamless to the user.

Figure 6 shows an embodiment of the system for performing the method described above. The system is a dual beam system 10 with a vertically mounted column 106 (for example SEM column) and a focused ion beam (FIB) column mounted at an angle (for example, an angle of approximately 52 degrees) from the vertical. The manipulator with a needle can be replaced by using a rod from the chip 200 as mentioned above. Such dual beam systems are commercially available, for example, from FEI Company, Hillsboro, Oregon, the assignee of the present application.

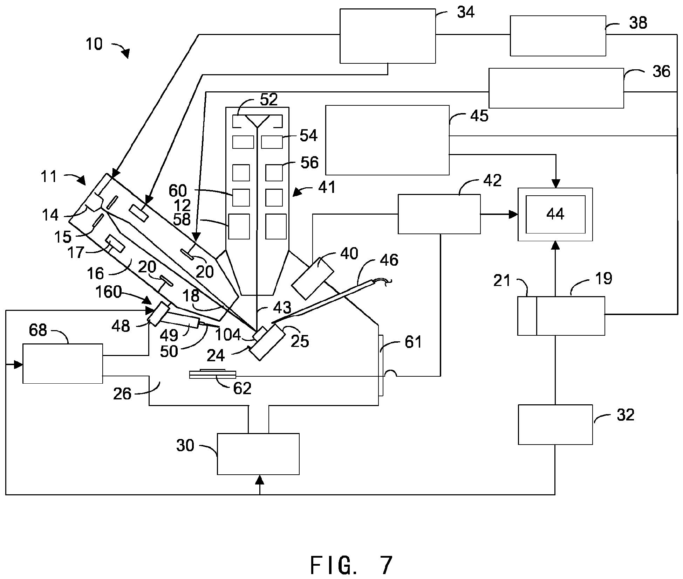

For more details on this system, a specific example of this system is shown in figure 7. While suitable hardware is provided below, the invention is not limited to being implemented in any particular type of hardware.

A scanning electron microscope 41, along with power supply and control unit 45, is provided with the dual beam system 10. An electron beam 43 is emitted from a cathode 52 by applying voltage between cathode 52 and an anode 54. Electron beam 43 is focused to a fine spot by means of a condensing lens 56 and an objective lens 58. Electron beam 43 is scanned two-dimensionally on the specimen by means of a deflection coil 60. Operation of condensing lens 56, objective lens 58, and deflection coil 60 is controlled by power supply and control unit 45.

Electron beam 43 can be focused onto substrate 104, which is on movable X-Y stage 25 within lower chamber 26. When the electrons in the electron beam strike substrate 104, secondary electrons are emitted. These secondary electrons are detected by secondary electron detector 40 as discussed below. STEM detector 62, located beneath the TEM sample holder 24 and the stage 25, can collect electrons that are transmitted through the sample mounted on the TEM sample holder as discussed above.

Dual beam system 10 also includes focused ion beam (FIB) system 11 which comprises an evacuated chamber having an upper neck portion 12 within which are located an ion source 14 and a focusing column 16 including extractor electrodes and an electrostatic optical system. The axis of focusing column 16 is tilted an angle, for example, 52 degrees from the axis of the electron column. The ion column 12 includes an ion source 14, an extraction electrode 15, a focusing element 17, deflection elements 20, and a focused ion beam 18. Focused ion beam 18 passes from ion source 14 through focusing column 16 and between electrostatic deflection means schematically indicated at 20 toward substrate 104, which comprises, for example, a semiconductor device positioned on movable X-Y stage 25 within lower chamber 26.

Stage 25 can preferably move in a horizontal plane (X and Y axes) and vertically (Z axis). Stage 25 can also tilt approximately sixty (60) degrees and rotate about the Z axis. In some embodiments, a separate TEM sample stage (not shown) can be used. Such a TEM sample stage will also preferably be moveable in the X, Y, and Z axes. A door 61 is opened for inserting substrate 104 onto X-Y stage 25 and also for servicing an internal gas supply reservoir, if one is used. The door is interlocked so that it cannot be opened if the system is under vacuum.

An ion pump 68 is employed for evacuating neck portion 12. The chamber 26 is evacuated with turbomolecular and mechanical pumping system 30 under the control of vacuum controller 32. The vacuum system provides within chamber 26 a vacuum of between approximately 1 x 10-7 Torr and 5 x 10⁻⁴ Torr. If an etch assisting gas, an etch retarding gas, or a deposition precursor gas is used, the chamber background pressure may rise, typically to about 1 x 10⁻⁵ Torr.

The high voltage power supply provides an appropriate acceleration voltage to electrodes in focusing column 16 for energizing and focusing ion beam 18. When it strikes substrate 104, material is sputtered, that is physically ejected, from the sample. Alternatively, ion beam 18 can decompose a precursor gas to deposit a material.

High voltage power supply 34 is connected to liquid metal ion source 14 as well as to appropriate electrodes in ion beam focusing column 16 for forming an approximately 1 keV to 60 keV ion beam 18 and directing the same toward a sample. Deflection controller and amplifier 36, operated in accordance with a prescribed pattern provided by pattern generator 38, is coupled to deflection plates 20 whereby ion beam 18 may be controlled manually or automatically to trace out a corresponding pattern on the upper surface of substrate 104. In some systems the deflection plates are placed before the final lens, as is well known in the art. Beam blanking electrodes (not shown) within ion beam focusing column 16 cause ion beam 18 to impact onto blanking aperture (not shown) instead of substrate 104 when a blanking controller (not shown) applies a blanking voltage to the blanking electrode.

The liquid metal ion source 14 typically provides a metal ion beam of gallium. The source typically is capable of being focused into a sub one-tenth micrometer wide beam at substrate 104 for either modifying the substrate 104 by ion milling, enhanced etch, material deposition, or for the purpose of imaging the substrate 104.

A charged particle detector 40, such as an Everhart Thornley or multi-channel plate, used for detecting secondary ion or electron emission is connected to a video circuit 42 that supplies drive signals to video monitor 44 and receiving deflection signals from a system controller 19. The location of charged particle detector 40 within lower chamber 26 can vary in different embodiments. For example, a charged particle detector 40 can be coaxial with the ion beam and include a hole for allowing the ion beam to pass. In other embodiments, secondary particles can be collected through a final lens and then diverted off axis for collection.

A micromanipulator 160, such as the AutoProbe 1000™ from Omniprobe, Inc., Dallas, Texas, or the Model MM3A from Kleindiek Nanotechnik, Reutlingen, Germany, can precisely move objects within the vacuum chamber. Micromanipulator 160 may comprise precision electric motors 48 positioned outside the vacuum chamber to provide X, Y, Z, and theta control of a portion 49 positioned within the vacuum chamber. The micromanipulator 160 can be fitted with different end effectors for manipulating small objects. In the embodiments described herein, the end effector is a thin probe 50.

A gas delivery system 46 extends into lower chamber 26 for introducing and directing a gaseous vapor toward substrate 104. U.S. Pat. No. 5,851,413 to Casella et al. for "Gas Delivery Systems for Particle Beam Processing," assigned to the assignee of the present invention, describes a suitable gas delivery system 46. Another gas delivery system is described in U.S. Pat. No. 5,435,850 to Rasmussen for a "Gas Injection System," also assigned to the assignee of the present invention. For example, iodine can be delivered to enhance etching, or a metal organic compound can be delivered to deposit a metal.

System controller 19 controls the operations of the various parts of dual beam system 10. Through system controller 19, a user can cause ion beam 18 or electron beam 43 to be scanned in a desired manner through commands entered into a conventional user interface (not shown). Alternatively, system controller 19 may control dual beam system 10 in accordance with programmed instructions stored in a memory 21.

In some embodiments, dual beam system 110 incorporates image recognition software, such as software commercially available from Cognex Corporation, Natick, Massachusetts, to automatically identify regions of interest, and then the system can manually or automatically extract samples in accordance with the invention. For example, the system could automatically locate similar features on semiconductor wafers including multiple devices, and take samples of those features on different (or the same) devices.

The above described embodiment uses existing, robust GIS technology to securely weld the rods in-situ onto the ends of the micromanipulator. But other mechanical or chemical methods to attach the rods onto the ends of the micromanipulator are within the scope of the present disclosure.

The innovative idea of the present invention is to pack a large number of usable rods into a small package. Rods are formed as needed instead of being made outside of the microscope and shaped one at a time inside a microscope before using. The small package may be inserted into the microscope for an inventory of needles that are already at the desired dimension that can be used when needed instead of one at a time techniques that require timely shaping processes. So, this idea would greatly simplify the operation since the rods can be integrated into the involved system/assembly/station.

As a comparative example, existing needle sharpening process burden may be 3%-8% of the whole operation process. Burden for in-situ rod attachment would be 0.3-0.7% of the whole operation process. Detailed comparison regarding needle throughput cost, inverted prep burden and plan view prep burden will be explained in table 1 below.

In some embodiments, a chip for one-year supply of rods may measure about 7.5mm x 0.5mm which can be easily store within a microscope. Detailed comparison regarding needle consumption and chip size requirement will be explained in table 2 below.

**• Table 1: Comparison of needle throughput cost, inverted prep burden and plan view prep burden between small dual beam (SDB), wafer dual beam (WDB) and rod**

| **Needle Throughput Cost** | **SDB** | **WDB** | **W Rod** |
|---|---|---|---|
| length of needle (um) | 50 | 50 | 144 |
| time to prepare | 0:30:00 | 0:30:00 | 0:10:00 |
| useful length (um) | 250 | 300 | 144 |
| time to replace | 0:20:00 | 1:30:00 | 0:00:00 |
| time per um length | 0:00:41 | 0:00:54 | 0:00:04 |
| | | | |

| **Inverted Prep Burden** | **SDB** | **WDB** | **W Rod** |
|---|---|---|---|
| time per sample | 0:30:00 | 0:30:00 | 0:30:00 |
| um consumed per sample | 3 | 3 | 3 |
| needle prep per sample | 0:02:02 | 0:02:42 | 0:00:12 |
| needle prep burden | 6.4% | 8.3% | 0.7% |
| | | | |

| **Plan View Prep Burden** | **SDB** | **WDB** | **W Rod** |
|---|---|---|---|
| time per sample | 0:45:00 | 0:45:00 | 0:45:00 |
| um consumed per sample | 2 | 2 | 2 |
| needle prep per sample | 0:01:22 | 0:01:48 | 0:00:08 |
| needle prep burden | 2.9% | 3.8% | 0.3% |

**• Table 2: Needle consumption and chip size requirement**

| Needle Consumption | Inverted | Plan View |
|---|---|---|
| time per sample | 0:30 | 0:45 |
| samples per day | 48 | 32 |
| um per sample | 3 | 2 |
| um per day | 144 | 64 |

| **Chip Size Requirement** | | |
|---|---|---|
| length of rod (um) | 144 | 144 |
| rods per day | 1 | 0.4 |
| rods per year | 365 | 162.2 |
| rod pitch (um) | 20 | 20 |
| required chip width (mm) | 7.3 | 3.2 |

The invention of this application has been described above both generically and with regard to specific embodiments. It will be apparent to those skilled in the art that various modifications and variations can be made in the embodiments without departing from the scope of the disclosure. Thus, it is intended that the embodiments cover the modifications and variations of this invention provided they come within the scope of the appended claims and their equivalents.

## Claims

1. A chip comprising:
a substrate;
a plurality of rods which are freestanding and spaced from the substrate and spaced from each other, wherein each rod has, longitudinally, a first end portion and a second end portion;
connectors for connecting each of the plurality of rods at both longitudinal end portions thereof respectively and holding them to the substrate,
wherein each rod can be individually raised away from the chip for use by a micromanipulator by cutting a rod from the connectors at both first and second end portions thereof.

2. The chip according to claim 1, wherein the rods and the connectors can be formed integrally.

3. The chip according to claim 2, wherein the connectors include anchors directly extending from the substrate, and further include tabs, spaced from the substrate, for connecting the rods to the connectors on both first and second end portions thereof respectively.

4. The chip according to claim 3, wherein the tabs are configured in such a way that they can be cut off in order to release each rod from the connectors at both first and second end portions thereof.

5. The chip according to claim 3, wherein each rod has a free tip at the first and the second end portions thereof respectively for attachment to the micromanipulator in situ.

6. A micromanipulator comprising a free end, wherein the free end of the micromanipulator has a needle attached thereto which is configured as the rod cut from the chip according to any one of claims 1-5.

7. A system for preparing a micromanipulator comprising:
a chip according to any one of claims 1-5;
a micromanipulator according to claim 6;
means for fixedly attaching a rod to the free end of the micromanipulator.

8. The system according to claim 7 wherein the system further includes a fixture on which the chip is mounted in such a way that the rod is oriented at an angle matching the free end of the micromanipulator and the first end portion of the rod abuts against the free end of the micromanipulator.

9. The system according to claim 8 wherein the system further includes cutting means for dicing the rods from the chip with the first end portion cut firstly and the second end portion secondly.

10. The system according to claim 8 wherein the system further includes means for rotating the chip to face the cutting means and/or means for rotating the rods for attachment thereof to the micromanipulator.

11. The system according to claim 10 wherein the free end of the micromanipulator can be shaped to conform to the shape of the free tip of each rod.

12. A chip comprising:
a substrate;
a plurality of rods which are spaced from the substrate and spaced from each other, wherein each rod has, longitudinally, a first end portion and a second end portion;
tabs for connecting each of the plurality of rods to at least one of the first end portion and the second end portion thereof; and
support elements for holding the rods and tabs to the substrate,
wherein each rod can be individually raised away from the chip for use by a micromanipulator by cutting a rod from its tabs.

13. The chip according to claim 12, wherein the rods are supported via the support elements by the substrate at least at one end of the substrate.

14. The chip according to claim 12 or 13, wherein the chip further includes piers beneath the support elements and on the substrate for connecting the support elements to the substrate.
